# EUROPEAN PATENT APPLICATION

(11) **EP 0 689 254 A1**
(43) Date of publication of application: **27.12.1995**
(21) Application number: 95109696.5
(22) Date of filing: 22.06.1995
(51) Int. Cl.: H01L 41/107

(54) **Accoustic isolator**

(30) Priority: 23.06.1994 US 264805
(71) Applicant: MOTOROLA, INC., Schaumburg, IL 60196 (US)
(72) Inventor: Gempe, Horst A., Phoenix, Arizona 85028 (US)
(74) Representative: Spaulding, Sarah Jane

(57) **Abstract**

An acoustic isolator includes a first piezoelectric device 14 and a second piezoelectric device 16 acoustically coupled through and electrically isolated by a circuit board 12. This provides electric isolation with relatively high power transfer efficiency in a small and inexpensive package.

## Description

### Field of the Invention

The present invention relates, in general, to semiconductor devices, and more particularly, to isolator devices.

### Background of the Invention

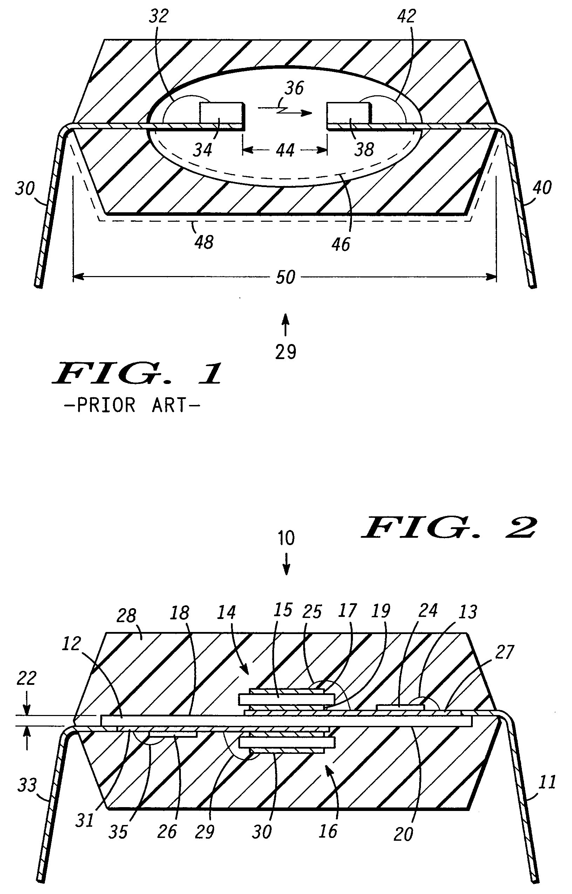

In electronics it is sometimes necessary to electrically isolate electronic devices which must nevertheless interact with one another. Conventionally this has been accomplished through the use of photovoltaic array optical isolators or pulse transformers. A cross section of a representative photovoltaic isolator 29 is shown in FIG. 1. Typically, an input signal is introduced to input lead 30. Input lead 30 is coupled, via wire bond 32, to photovoltaic device 34. Photovoltaic device 34 converts the electrical energy from input lead 30, into optical energy, represented by arrow 36. The optical energy is received by photovoltaic device 38. Photovoltaic device converts the optical energy back into electrical energy, and provides the electrical signal to output lead 40, via wirebond 42. Consequently, a first circuit coupled to input lead 30 can interact with a second circuit coupled to output lead 40, while the two circuits are nevertheless electrically isolated from one another. This device, as shown, is packaged as a typical, plastic encapsulated dual in-line package.

Isolators must meet regulatory parameters when used in some applications. For example, the isolation barrier distance, the distance 44 between the photovoltaic devices 34 and 38 must be at least 0.4 millimeters. The internal creepage, the shortest distance along a non-bonded internal seam from one side to the other, represented by dotted line 46, must be' at least 4.0 millimeters. The external creepage, the shortest distance along the external edge of the package between the isolated leads, represented by dotted line 48, must be at least 8.0 millimeters. The external clearance, the straight-line distance between the isolated leads must be at least 8.0 millimeters. The input/output isolation withstand voltage must be at least 3750 volts rms. The isolation resistance at 500 Volts DC must be 10E-12 amps. It is difficult to meet these regulatory parameters in a small and efficient package.

Photovoltaic isolators such as that represented in FIG. 1 have the significant disadvantage of being relatively expensive, and having very low power transfer ability and efficiency. A typical optical isolator transfers only about 1 microwatt.

Additionally, pulse transformers have been used to electrically isolate individual components. However, small pulse transformers are not available to meet regulatory requirements. Additionally, pulse transformers are very expensive. These pulse transformers are also too large for some uses and they are not easily integrated into some electronic circuitry.

Consequently it is desirable to have an isolator with high power transfer efficiency, small size, low cost, and which meets regulatory requirements.

### Brief Description of the Drawings

FIG. 1 is a cross section side view representing a prior art optical isolator device;
FIG. 2 is a cross-sectional side view representing an acoustic isolator device; and
FIG. 3 is a cross-sectional side view representing an acoustic isolator device.

### Detailed Description of the Drawings

According to one embodiment of the present invention, an acoustic isolator device is provided by using a circuit board as an acoustical medium between two piezoelectric devices. The circuit board provides an acoustical medium as well as electric isolation between the two piezoelectric devices. A preferred embodiment of the present invention provides a small and inexpensive isolator that is able to achieve relatively high power efficiency in a small and easy to produce package. Also, the embodiment is easily designed to meet regulatory requirements.

Turning now to the figures for a more detailed description of the preferred embodiments of the present invention, FIG. 2 is a cross-sectional side view representing an acoustic isolator device. FIG. 2 shows an acoustic isolator device 10. In this embodiment the acoustic isolator device 10 has a circuit board 12. This circuit board can be made from ceramic material such as titanium oxide, flex board such as polyimide, or alumina. The isolator 10 also has a first piezoelectric device 14 and a second piezoelectric device 16. The first piezoelectric device 14 is mounted on a first side 18 of circuit board 12. The second piezoelectric device 16 is mounted on a second side 20 of circuit board 12. The mounting may be accomplished with an adhesive such as Speed Bonder™ 324 manufactured by Loctite Corporation. These piezoelectric devices may comprise any piezoelectric material 15 between two electrical contacts 17 and 19. The electrical contacts can be plated or sputtered upon the piezoelectric material. The mounting of the first piezoelectric device 14 and the second piezoelectric device 16 on opposite sides of circuit board 12 provides electric isolation and an acoustical coupling medium between the first and second piezoelectric devices. The thickness 22 of the circuit board determines the isolation barrier distance between the piezoelectric devices 14 and 16. To meet regulatory parameters on isolation barrier distance the circuit board can be made to have a thickness 22 of at least 0.4 millimeters.

This embodiment also has an input circuit 24. The input circuit is electrically connected to leads 11 through wire bonds 13. In one embodiment the input circuit 24 contains an oscillator with a frequency equal to a resonant frequency of the piezoelectric devices 14 and 16. Optimally, the frequency used is a resonant frequency for thickness mode oscillation of the piezoelectric devices 14 and 16. It will be understood that thickness mode oscillation provides for the most efficient power transfer through the circuit board 12.

The input circuit 24 is electrically connected to the first piezoelectric device 14 through wire bond 25 and traces 27. Likewise, the second piezoelectric device 16 is electrically connected to a output circuit 26 through wire bond 29 and traces 31. The output circuit is electrically connected to lead 33 through wire bond 35. It will be recognized by those skilled in the art that the output circuit 26 can contain a variety of different types of devices for which this isolator device provides isolation. For example, the output circuit could contain a rectifying voltage regulator for use as a isolated DC/DC converter. The output circuit could also contain a FET drive circuit. The output circuit could also contain FETs for use as a solid state relay. The acoustic isolator device 10 also comprises encapsulating material 28 encapsulating the circuit board and the first and second piezoelectric devices. The encapsulating material 28 can be any of the encapsulating materials, such as epoxy, that are well known in the art.

It will be understood by those skilled in the art that the piezoelectric devices must be free to physically oscillate within the package. That is to say, there must be a slight amount of open space separating the piezoelectric devices from the encapsulating material 28. Consequently, prior to molding, a die coat 30 is applied between the piezoelectric devices and the encapsulating material. As will be recognized, the die coat 30 is extremely thin relative to encapsulating material 28 and piezoelectric devices 14 and 16 and therefore is not shown as a separate detail in the figure. The use of the die coat in manufacturing creates a gap between the encapsulating material 28 and the piezoelectric devices 14 and 16 in which the piezoelectric devices can oscillate. There are several other ways to provide the gap for the piezoelectric devices 14 and 16. For example, a preformed die cap could be placed between the piezoelectric devices 14 and 16 and the encapsulating material 28.

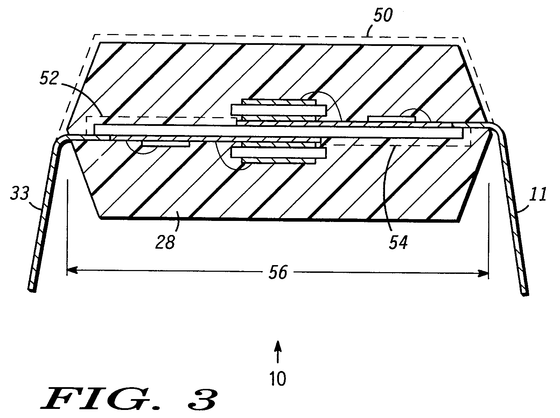

Turning now to FIG. 3, FIG. 3 is a cross sectional side view representing an acoustic isolator device. To meet regulatory parameters the device 10 is designed and encapsulating material 28 is molded such that the external creepage, indicated by dotted line 50, the shortest distance around encapsulating material 28 between leads 33 and 11, is greater than 8 millimeters. Additionally, the acoustic isolator device 10 is designed such that internal creepage path, the distance along a non-bonded seam between isolated sides, meets regulatory parameters that require at least 4 millimeters of internal creepage. In this embodiment the input circuit to output lead internal creepage, indicated by dotted line 52, and the output circuit to input lead internal creepage, indicated by dotted line 54, are both greater than 4 millimeters. The acoustical isolator device is designed such that external clearance 56, the straight-line distance between leads 11 and 33, meets regulatory parameters that require 8 millimeters of external clearance. Additionally, it will be recognized that regulatory parameters such as an isolation resistance of 10E-12 amps at 500 volts and input/output isolation withstand voltage of 3750 volts may be met using this embodiment.

By now it should be recognized that an acoustical isolator device has been provided that provides the advantages of a high power transfer efficiency, a low cost, a small size, and can be easily adapted to meet regulatory requirements. For example, this embodiment can have 10,000 volts rms isolation voltage while providing 100 milliwatts power transfer at 50% efficiency.

While the invention has been particularly shown and described with reference to the preferred embodiments thereof, it will be understood by those skilled in the art that the foregoing and other changes to the form and detail may be made therein without departing from the spirit and scope of the invention.

## Claims

1. An acoustic isolator device (10) comprising:
an acoustical medium circuit board (12) having a first side (18) and a second side (20);
an input circuit (24) attached to the first side (18) of the acoustical medium circuit board (12);
an output circuit (26) attached to the second side (20) of the acoustical medium circuit board (12);
a first piezoelectric device (14) attached to the first side (18) of the acoustical medium circuit board (12) and electrically connected to the input circuit (24);
a second piezoelectric device (16) attached to the second side (20) of the acoustical medium circuit board (12) and electrically connected to the output circuit (26); and
wherein the first and second piezoelectric devices (14, 16) are acoustically coupled through the acoustical medium circuit board (12).

2. The isolator as in claim 1 further comprising an encapsulating material (28), encapsulating the acoustical medium circuit board (12).

3. The isolator as in claim 2 further comprising die coat between the first piezoelectric device (14) and the encapsulating material (28), and die coat (30) between the second piezoelectric device (16) and the encapsulating material (28).

4. An acoustic isolator package (10) comprising:
an acoustical medium circuit board (12) having a first side (18) and a second side (20);
a first piezoelectric device (14) attached to the first side (18) of the acoustical medium circuit board (12);
a second piezoelectric device (16) attached to the second side (20) of the acoustical medium circuit board (12) and acoustically coupled to the first piezoelectric device (14) through the acoustical medium circuit board (12); and
encapsulating material (28) encapsulating the acoustical medium circuit board (12) and the first and second piezoelectric devices (14, 16).

5. The package as in claim 4 further comprising die coat (30) between the first piezoelectric device (14) and the encapsulating material (20), and die coat (30) between the second piezoelectric device (14) and the encapsulating material (28).

6. The package (10) as in claim 4 wherein external creepage (15) is not less than 8 millimeters.

7. The package as in claim 4 wherein internal creepage (52) is not less than 4 millimeters.

8. An acoustic isolator device (10) comprising:
a circuit board (12) having a first side (18) and a second side (20);
a first piezoelectric device (14) attached to the first side (18) of the circuit board (12);
a second piezoelectric device (16) attached to the second side (20) of the circuit board (12);
an input circuit (24) comprising an oscillator with a frequency equal to a resonant oscillation frequency of the first and second piezoelectric devices (14, 16), the input circuit (24) attached to the first side (18) of the circuit board (12) and electrically connected to the first piezoelectric device (14);
an output circuit (26) attached to the second side (20) of the circuit board (12) and electrically connected to the second piezoelectric device (16); and
encapsulating material (28) encapsulating the circuit board (12) and the first and second piezoelectric devices (14, 16).

9. An acoustic isolator device (10) comprising:
an acoustical medium (12) having a first end (18) and a second end (20);
a first piezoelectric device (14) attached to the first end (18) of the acoustical medium circuit board (12);
a second piezoelectric device (16) attached to the second end (20) of the acoustical medium (12) and acoustically coupled to the first piezoelectric device (14) through the acoustical medium (12) and electrically isolated from the first piezoelectric device (14), the isolator device having an input/output isolation that can withstand a voltage of at least 3750 volts rms.
